# EUROPEAN PATENT APPLICATION

(11) **EP 2 557 690 A1**
(43) Date of publication of application: **13.02.2013**
(21) Application number: 12275018.5
(22) Date of filing: 21.02.2012
(51) Int. Cl.: H03K 17/16

(54) **Output driving circuit and transistor output circuit**

(30) Priority: 12.08.2011 KR 20110080760
(71) Applicant: Samsung Electro-Mechanics Co., Ltd, Suwon, Gyunggi-Do (KR)
(72) Inventor: Heo,, Chang Jae, 445-700 Gyeonggi-do (KR)
(74) Representative: Powell, Timothy John

(57) **Abstract**

The present invention relates to an output driving circuit and a transistor output circuit. In accordance with an embodiment of the present invention, an output driving circuit including: a first driving circuit unit driven according to on operation of a first switch to supply high voltage power source to a gate of an output transistor; a second driving circuit unit driven by a one-shot pulse generated according to on operation of a second switch, which operates complementarily with the first switch, to discharge a gate-source capacitance of the output transistor; and an output driving voltage clamping unit disposed between a high voltage power source terminal and the gate of the output transistor in parallel with the first driving circuit unit to maintain a gate potential of the output transistor discharged according to the on operation of the second switch is provided. Further, a transistor output circuit using the same is provided.

## Description

### CROSS-REFERENCE TO RELATED APPLICATIONS

Claim and incorporate by reference domestic priority application and foreign priority application as follows:

### "CROSS REFERENCE TO RELATED APPLICATION

This application claims the benefit under 35 U.S.C. Section 119 of Korean Patent Application Serial No. 10-20111-0080760, entitled filed August 12, 2011, which is hereby incorporated by reference in its entirety into this application."

### BACKGROUND OF THE INVENTION

### 1. Field of the Invention

The present invention relates to an output driving circuit and a transistor output circuit, and more particularly, to an output driving circuit and a transistor output circuit that are capable of stably operating when a high voltage lower than a source-drain breakdown voltage but higher than a gate-source breakdown voltage is applied to a gate of an output transistor.

### 2. Description of the Related Art

A p-channel transistor, for example, an operating voltage of a p-channel LDMOS is determined by a source-drain breakdown voltage BVsd, a source-gate breakdown voltage BVsg, and a gate-drain breakdown voltage BVgd, and among them, the source-gate breakdown voltage BVsg is the lowest. The source-gate breakdown voltage BVsg is determined by a thickness of a gate oxide. This is because it is impossible to increase the thickness of the gate oxide without limit since a threshold voltage Vth, a source-drain current Isd, and an on-resistance Ron of the transistor are determined by the thickness of the oxide. When a power voltage is lower than the source-drain breakdown BVsd but higher than the source-gate breakdown voltage BVsg, it is fine that the power voltage is connected to a source terminal and a low potential (ground and so on) is connected to a drain terminal, but when the power voltage and the low potential (ground) voltage are applied to a gate terminal in order to operate this transistor, the power voltage is applied to the source-gate voltage Vsg. Since this power voltage is higher than the source-gate breakdown voltage BVsg, the transistor device can be broken.

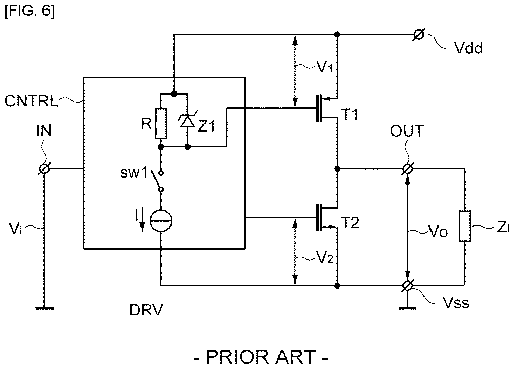

FIG. 6 is a view roughly showing a conventional output driving circuit.

In a conventional technology of FIG. 6, when a switch SW1 is closed to turn on an output transistor T1, a given current I flows in a resistor R and a zener diode Z1 connected to a power voltage VDD and a gate of the output transistor T1 and a source-gate potential of the output transistor T1 becomes lower than a source-gate breakdown voltage BVsg but higher than a threshold voltage Vth by the zener diode Z1 so that the output transistor T1 is driven. On the contrary, the switch SW1 is opened to turn off the output transistor T1 and a gate potential of the output transistor T1 is increased to the power voltage VDD by the resistor R connected to the power voltage VDD and the gate of the output transistor T1 so that the output transistor T1 is turned off.

Meanwhile, unlike FIG. 6, in some cases, a current mirror, not the resistor R, is used as a means of turning off the output transistor T1 to operate the output transistor T1 in a relatively high frequency.

### SUMMARY OF THE INVENTION

The conventional technology of FIG. 6 is disadvantageous to a relatively high frequency since a gate-source capacitance of the output transistor T1 is charged through the resistor and discharged through a current source and increases current consumption since a current I continuously flows through the resistor R and the zener diode Z1 to maintain an on-state of the output transistor T1.

Further, when a current mirror is used as a means of turning off the output transistor T1 to operate the output transistor T1 in a relatively high frequency, a high current mirror ratio is required to charge the gate-source capacitance of the output transistor T1 at high speed and a large current I is required to discharge the gate-source capacitance of the output transistor T1 at high speed like FIG. 6. Further, even in this case, since the large current I continuously flows through the zener diode Z1 to maintain the on-state of the output transistor T1 like FIG. 6, current consumption is increased.

The present invention has been invented in order to overcome the above-described problems and it is, therefore, an object of the present invention to provide an output driving circuit and a transistor output circuit that are capable of stably operating when a high voltage lower than a source-drain breakdown voltage but higher than a gate-source breakdown voltage is applied to a gate of an output transistor.

Further, it is another object of the present invention to provide an output driving circuit and a transistor output circuit that are capable of performing stable operation in a high frequency and moreover, performing stable operation with low current consumption.

In accordance with a first embodiment of the present invention to achieve the object, there is provided an output driving circuit including: a first driving circuit unit including a first transistor driven according to on operation of a first switch to supply high voltage power source to a gate of an output transistor; a second driving circuit unit including a second transistor driven by a one-shot pulse generated according to on operation of a second switch, which operates complementarity with the first switch, to discharge a gate-source capacitance of the output transistor; and an output driving voltage clamping unit disposed between a high voltage power source terminal and the gate of the output transistor in parallel with the first driving circuit unit to maintain a gate potential of the output transistor discharged according to the on operation of the second switch.

In accordance with another embodiment of the present invention, the above-described second driving circuit unit includes the second switch which operates complementarily with the first switch and discharges a current flowing through the output driving voltage clamping unit to a low voltage power source terminal according to the on operation; a pulse generator which generates the one-shot pulse for driving the second transistor according to the on operation of the second switch; and the n-channel second transistor which is driven by the one-shot pulse to discharge the gate-source capacitance of the output transistor.

In accordance with another embodiment of the present invention, the above-described first driving circuit unit includes the first switch; the p-channel first transistor having a source electrode connected to the high voltage power source terminal and being driven according to the on operation of the first switch to supply the high voltage power source to the gate of the output transistor; and a first transistor driving voltage clamping unit for clamping a driving voltage supplied from the high voltage power source terminal to a gate of the first transistor according to the on operation of the first switch.

Furthermore, in an example, the first transistor driving voltage clamping unit includes a resistor and a first zener diode which are disposed between the high voltage power source terminal and the gate of the first transistor to be connected each other in parallel.

Further, in another example, the first transistor driving voltage clamping unit includes a first zener diode disposed between the high voltage power source terminal and the gate of the first transistor; a current mirror connected to the first zener diode in parallel; and a third switch connected to a lower end of the current mirror, an opposite side of the gate of the first transistor, to operate complementarily with the first switch.

At this time, in accordance with another example, the current mirror has a mirror structure of third and fourth transistors of which source electrodes are connected to the high voltage power source terminal, wherein the third and fourth transistors are p-channel MOSFETs or p-channel LDMOS FETs, a drain electrode of the fourth transistor is connected to the gate of the first transistor, and a drain electrode of the third transistor is connected to the third switch and gate electrodes of the third and fourth transistors. At this time, the third switch may consist of an n-channel MOSFET or an n-channel LDMOS FET.

Further, in accordance with an embodiment of the present invention, the output driving voltage clamping unit includes a second zener diode disposed between the high voltage power source terminal and the gate of the output transistor.

Further, in accordance with an embodiment of the present invention, a gate-source capacitance of the first transistor is smaller than that of the output transistor.

In accordance with another embodiment of the present invention, the first and second switches consist of n-channel MOSFETs or n-channel LDMOS FETs.

And in accordance with another embodiment of the present invention, the output transistor is a p-channel MOSFET or a p-channel LDMOS FET which is driven according to driving of the second driving circuit unit to output the high voltage power source.

Further, in accordance with a second embodiment of the present invention to achieve the object, there is provided a transistor output circuit including: a p-channel output transistor of which a source electrode is connected to a high voltage power source terminal and which outputs high voltage power source through a drain electrode according to driving; an n-channel output transistor which operates complementarily with the p-channel output transistor and outputs power from a drain electrode connected to the drain electrode of the p-channel output transistor to a low voltage power source terminal connected to a source electrode according to driving; and an output driving circuit according to one of the above-described embodiments which drives each of the p-channel and n-channel output transistors according to complementary switching operation.

In accordance with another embodiment of the present invention, an output driving voltage clamping unit of the output driving circuit includes a second zener diode disposed between the high voltage power source terminal and a gate of the p-channel output transistor.

In accordance with another embodiment, first and second switches of the output driving circuit consist of n-channel MOSFETs or n-channel LDMOS FETs.

### BRIEF DESCRIPTION OF THE DRAWINGS

These and/or other aspects and advantages of the present general inventive concept will become apparent and more readily appreciated from the following description of the embodiments, taken in conjunction with the accompanying drawings of which:

FIG. 1 is a block diagram roughly showing an output driving circuit in accordance with an embodiment of the present invention;

FIG. 2 is a circuit diagram showing a transistor output circuit including the output driving circuit in accordance with an embodiment of the present invention;

FIG. 3 is a circuit diagram showing a transistor output circuit including an output driving circuit in accordance with another embodiment of the present invention;

FIG. 4 is a graphic showing a simulation result of the output driving circuit in accordance with an embodiment of the present invention;

FIG. 5 is a graphic showing an effect of a one-shot pulse in accordance with an embodiment of the present invention; and

FIG. 6 is a view roughly showing a conventional output driving circuit.

### DETAILED DESCRIPTION OF THE PREFERABLE EMBODIMENTS

Embodiments of the present invention to achieve the above-described objects will be described with reference to the accompanying drawings. In this description, the same elements are represented by the same reference numerals, and additional description which is repeated or limits interpretation of the meaning of the invention may be omitted.

Before the detailed description, in this specification, when an element is referred to as being "connected" or "coupled" to another element, it can be "directly" connected or coupled to the other element or connected or coupled to the other element with another element interposed therebetween, unless it is referred to as being "directly connected" or "directly coupled" to the other element.

Although the singular form is used in this specification, it should be noted that the singular form can be used as the concept representing the plural form unless being contradictory to the concept of the invention or clearly interpreted otherwise.

It should be understood that the terms such as "having", "including", and "comprising" used herein do not preclude existence or addition of one or more other features or elements or combination thereof.

First, an output driving circuit in accordance with a first embodiment will be described in detail with reference to the drawings.

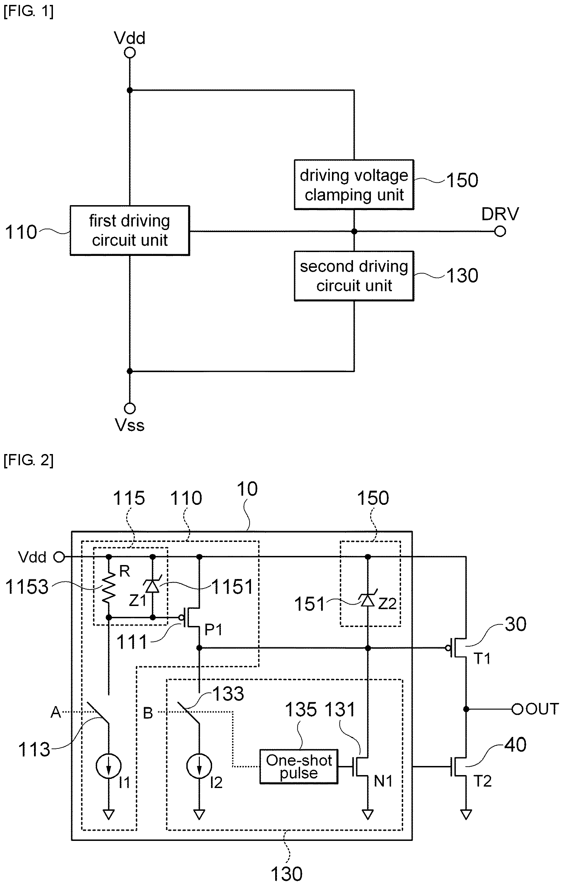

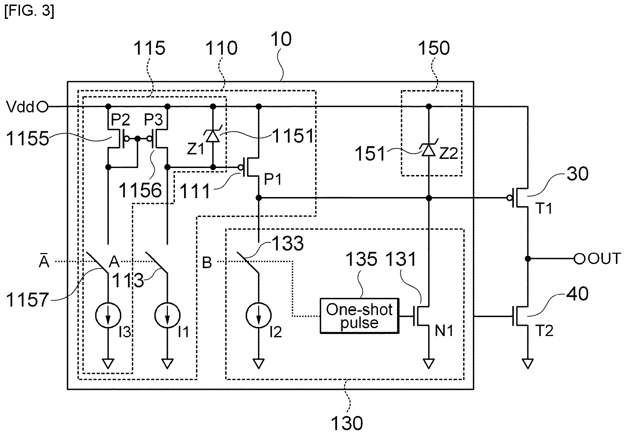

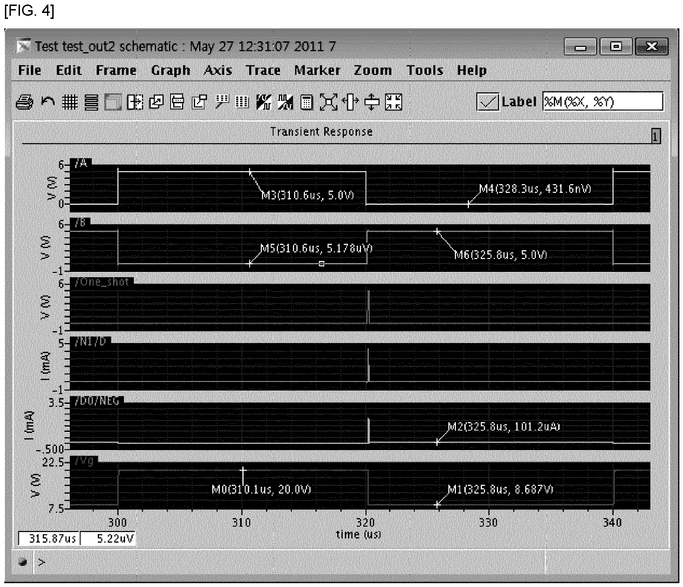

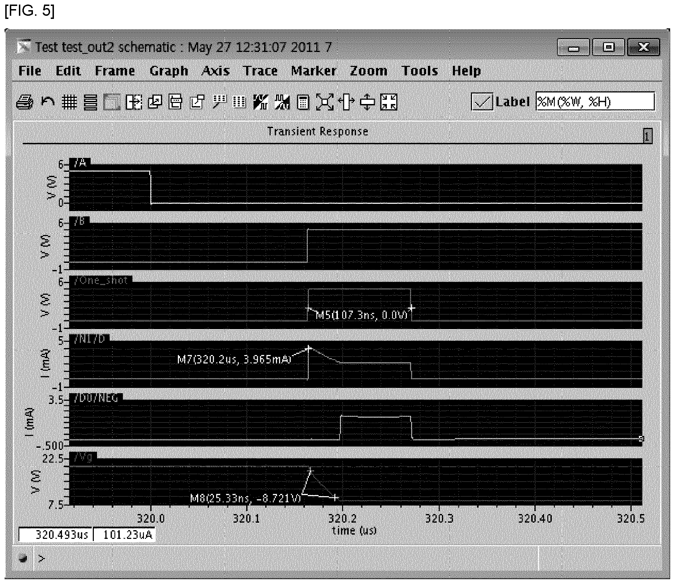

FIG. 1 is a block diagram roughly showing an output driving circuit in accordance with an embodiment of the present invention. FIG. 2 is a circuit diagram showing a transistor output circuit including the output driving circuit in accordance with an embodiment of the present invention. FIG. 3 is a circuit diagram showing a transistor output circuit including an output driving circuit in accordance with another embodiment of the present invention. FIG. 4 is a graphic showing a simulation result of the output driving circuit in accordance with an embodiment of the present invention. FIG. 5 is a graphic showing an effect of a one-shot pulse in accordance with an embodiment of the present invention.

An output driving circuit in accordance with an embodiment of the present invention will be described with reference to FIGS. 1, 2, or/and 3. Referring to FIGS. 1, 2, or/and 3, an output driving circuit 10 includes a first driving circuit unit 110, a second driving circuit unit 130, and an output driving voltage clamping unit 150.

Specifically, the first driving circuit unit 110 includes a first transistor 111 which is driven according to on operation of a first switch 113 to supply high voltage power source Vdd to a gate of an output transistor. At this time, in an example, the output transistor may be a p-channel transistor 30. Moreover, in a more specific example, the output transistor may be a p-channel MOSFET or a p-channal lateral double diffused metal oxide semiconductor (LDMOS) FET When the output transistor is a p-channel transistor, since the high voltage power source Vdd is uniformly supplied to the gate according to the driving of the first transistor 111, the transistor is turned off. At this time, in another example, the first transistor 111 may be a p-channel transistor, for example, a p-channel MOSFET or a p-channel LDMOS FET. Further, at this time, in an example, the first switch 113 may consist of an n-channel MOSFET or an n-channel LDMOS FET.

In an embodiment, the first driving unit 110 will be described in more detail with reference to FIGS. 2 or/and 3. The first driving unit 110 may include the first switch 113, the first transistor 111, and a first transistor driving voltage clamping unit 115.

At this time, the first transistor 111 may be a p-channel transistor. A source electrode of the p-channel transistor is connected to a high voltage power source terminal Vdd, and the p-channel transistor is driven according to the on operation of the first switch 113. The p-channel transistor supplies the high voltage power source Vdd to the gate of the output transistor, for example, the p-channel output transistor by its driving. Accordingly, the p-channel output transistor 30, to which the high voltage power source Vdd is applied as gate power, is turned off.

Continuously, referring to FIGS. 2 or/and 3, the first transistor driving voltage clamping unit 115 clamps a driving voltage supplied from the high voltage power source terminal Vdd to the gate of the first transistor 111 according to the on operation of the first switch 113. Accordingly, the first transistor 111 is protected so that a source-gate voltage of the first transistor 111 does not exceed a breakdown voltage BVsg.

More specifically, an example will be described with reference to FIG. 2. The first transistor driving voltage clamping unit 115 is disposed between the high voltage power source terminal Vdd and the gate of the first transistor 111 and includes a resistor 1153 and a first zener diode 1151. The resistor 1153 and the first zener diode 1151 are disposed between the high voltage power source terminal Vdd and the gate of the first transistor 111 to be connected each other in parallel. At this time, according to the on operation of the first switch 113, a constant current I1 flows out to a low voltage power source supply Vss, that is, a ground through the first switch 113.

Further, another example will be described in detail with reference to FIG. 3. Referring to FIG. 3, the first transistor driving voltage clamping unit 115 can replace the resistor 1153 of FIG. 2 with a current mirror structure. For example, the first transistor driving voltage clamping unit 115 may include the first zener diode 1151 disposed between the high voltage power source terminal Vdd and the gate of the first transistor 111, a current mirror connected to the first zener diode 1151 in parallel, and a third switch 1157 connected to a lower end of the current mirror, an opposite side of the gate of the first transistor 111 to operate complementarily with the first switch 113. Another specific example will be described with reference to FIG. 3. The current mirror has a mirror structure of third and fourth transistors 1155 and 1156 of which source electrodes are connected to the high voltage power source terminal Vdd. A drain electrode of the fourth transistor 1156 is connected to the gate of the first transistor 111, and a drain electrode of the third transistor 1155 is connected to the third switch 1157 and gate electrodes of the third and fourth transistors 1155 and 1156. At this time, the third and fourth transistors 1155 and 1156 may be p-channel MOSFETs or p-channel LDMOS FETs. Further, at this time, the third switch 1157 may consist of an n-channel MOSFET or an n-channel LDMOS FET.

Again, another embodiment of the present invention will be described with reference to FIGS. 2 or/and 3. A gate-source capacitance of the first transistor 111 is smaller than that of the output transistor. It is possible to increase a charging speed in the first transistor driving voltage clamping unit by sufficiently reducing the gate-source capacitance of the first transistor 111 than that of the output transistor. At this time, the first transistor 111 may be formed smaller than the output transistor. For example, when the first transistor 111 is sufficiently smaller than the p-channel output transistor 30, for example, about 1/20 of the p-channel output transistor 30, since the gate-source capacitance of the first transistor 111 is sufficiently smaller than that of the p-channel output transistor 30, it is possible to increase the charging speed in the first transistor driving voltage clamping unit, particularly, the charging speed by the resistor 1153 of the first transistor driving voltage clamping unit. Accordingly, it is possible to turn off the p-channel first transistor 111 at sufficiently high speed even when the current source 11, which flows out through the first transistor driving voltage clamping unit according to the on operation of the first switch 113, is a small current. Therefore, it is possible to reduce current consumption and facilitate operation in a relatively high frequency by designing the current source I1 small.

At this time, in accordance with another embodiment, the first switch 113 may consist of an n-channel transistor, for example, an n-channel MOSFET or an n-channel LDMOS FET. At this time, the n-channel transistor may have a low gate-source breakdown voltage BVgs, for example, about 5V, but a high drain-source breakdown voltage BVds corresponding to the high voltage power source Vdd.

The operation of the first driving circuit unit 110 in accordance with an example will be described in detail with reference to FIG. 2. In FIG. 2, the first switch 113 A of the first driving circuit unit 110 and a second switch 133 B of the second driving circuit unit 130 operate with different phases. When the first switch 113 A is closed, the second switch 133 B is opened, and when the first switch 113 A is opened, the second switch 133 B is closed. At this time, when the first switch 113 A is closed and the second switch 133 B is opened, a current of the current source 11 flows in the resistor 1153 R and the first zener diode 1151 Z1 and the gate potential of the first transistor 111 P1 becomes higher than a threshold voltage Vth but lower than the source-gate breakdown voltage BVsg so that the first transistor 111 P1 is turned on. When the first transistor 111 P1 is turned on, the gate-source capacitance of the output transistor T1 is rapidly charged so that the output transistor T1 is turned off.

Further, the operation of the first driving circuit unit 110 in accordance with an example will be described in detail with reference to FIG. 3. In FIG. 3, the first switch 113 A of the first driving circuit unit 110 and the second switch 133 B of the second driving circuit unit 130 operate with different phases, and the first switch 113 A and the third switch 1157 □ of the first driving circuit unit 110 operate complementarity with each other. That is, when the first switch 113 A is closed, the second switch 133 B and the third switch 1157 are opened, and when the first switch 113 A is opened, the second switch 133 B and the third switch 1157 are closed. At this time, when the first switch 113 A is opened and the third switch 1157 is closed, a current flows in the fourth transistor 1156 P3 by the current mirror ratio by the third and fourth transistors 1155 and 1156 with a current mirror structure and the gate-source capacitance of the first transistor 111 P1 is charged to increase the gate potential of the first transistor 111 P1 up to the high voltage power source Vdd so that the first transistor 111 P1 is turned off. On the contrary, when the first switch 113 A is closed and the third switch 1157 is opened, the current source 11 flows through the first switch 113 A and the gate potential of the first transistor 111 P1 becomes higher than the threshold voltage Vth but lower than the source-gate breakdown voltage BVgs so that the first transistor 111 P1 is turned on. When the first transistor 111 P1 is turned on, the gate-source capacitance of the output transistor T1 is rapidly charged so that the output transistor T1 is turned off. In FIG. 3, since the first transistor 111 P1 is much smaller than the output transistor T1, rapid switching can be performed with a small current of 13.

Next, the second driving circuit unit 130 will be continuously described with reference to FIGS. 1, 2, or/and 3. The second driving circuit unit 130 includes a second transistor 131 driven by a one-shot pulse generated according to the on operation of the second switch 133, which operates complementarily with the first switch 113, to discharge the gate-source capacitance of the output transistor. At this time, in an example, the second transistor 131 may be an n-channel transistor, for example, an n-channel MOSFET or an n-channel LDMOS FET. When the second transistor 131 is driven, the charged gate-source capacitance can be rapidly discharged from the gate of the output transistor connected to the drain electrode to the low voltage power source supply connected to the source electrode, for example, the ground.

In this embodiment, the output transistor is driven according to the driving of the second driving circuit unit 130. In an example, the output transistor may be a p-channel transistor 30. Moreover, in a more specific example, the output transistor may be a p-channel MOSFET or a p-channel LDMOS FET which outputs the high voltage power source Vdd according to the driving of the second driving circuit unit 130.

In an embodiment, when describing in detail with reference to FIG. 2, the second driving circuit unit 130 includes the second switch 133, a pulse generator 135, and the second transistor 131. The second switch 133 operates complementarily with the first switch 113 of the first driving circuit unit 110. It is possible to discharge a current flowing through the output driving voltage clamping unit 150 to the low voltage power source terminal Vss according to the on operation of the second switch 133. The pulse generator 135 is operated according to the on operation of the second switch 133 and generates the one-shot pulse for driving the second transistor 131. And the second transistor 131 may be an n-channel transistor and the n-channel second transistor 131 is driven by receiving the one-shot pulse generated by the pulse generator 135 as gate power. According to the driving of the n-channel second transistor 131, the gate-source capacitance can be rapidly discharged from the gate electrode of the output transistor connected to the drain electrode to the low voltage power source supply Vss connected to the source electrode, for example, the ground. After the gate-source capacitance of the gate electrode of the output transistor is rapidly discharged by the n-channel second transistor 131, when a current flowing through the output driving voltage clamping unit 150 is discharged to the low voltage power source terminal through the turned-on second switch 133, the gate potential of the discharged output transistor can be uniformly maintained. Accordingly, the output transistor is driven, and the high voltage power source Vdd of the source electrode of the p-channel output transistor 30 is output through the drain electrode.

At this time, according to another embodiment, the second switch 133 may consist of an n-channel transistor, for example, an n-channel MOSFET or an n-channel LDMOS FET. At this time, the n-channel transistor, which forms the second switch 133, has a low gate-source breakdown voltage BVgs, for example, 5V but a high drain-source breakdown voltage BVds corresponding to the high voltage power source Vdd.

The operation of the second driving circuit unit 130 in accordance with an example will be described in detail with reference to FIGS. 2 or/and 3. In FIGS. 2 or/and 3, the first switch 113 A of the first driving circuit unit 110 and the second switch 133 B of the second driving circuit unit 130 operate with different phases. When the first switch 113 A is opened and the second switch 133 B is closed, the second transistor 131 N1 is instantaneously operated by the one-shot pulse generated by the pulse generator 135 to rapidly discharge the gate-source capacitance of the output transistor T1. The second transistor 131 N1 is turned off after rapidly discharging the gate-source capacitance by the one-shot pulse. At this time, a current of a current source 12 flows in the second zener diode 151 Z2 of the output driving voltage clamping unit 150 so that the gate potential of the output transistor T1 is uniformly maintained in a state in which the gate-source capacitance of the output transistor T1 is discharged and the output transistor T1 is operated. The high voltage power source Vdd is output from the source electrode through the drain electrode according to the driving of the output transistor T1.

At this time, the current source 12, which turns on the output transistor T1, can be designed small since the second transistor 131 N1, which is operated by the one-shot pulse, discharges the gate-source capacitance of the output transistor T1 first. Accordingly, it is possible to reduce current consumption and facilitate operation in a relatively high frequency.

Next, the output driving voltage clamping unit 150 will be continuously described with reference to FIGS. 1, 2, or/and 3. The output driving voltage clamping unit 150 is disposed between the high voltage power source terminal Vdd and the gate of the output transistor in parallel with the first driving circuit unit 110 and maintains the gate potential of the discharged output transistor according to the on operation of the second switch 133. Accordingly, the output transistor is driven by the driving of the second driving circuit unit 130, more specifically, by the on operation of the second switch 133, and the high voltage power source Vdd may be output through the output transistor.

When describing in detail with reference to FIGS. 2 or/and 3, in an embodiment, the output driving voltage clamping unit 150 includes the second zener diode 151 disposed between the high voltage power source terminal Vdd and the gate of the output transistor. According to the on operation of the second switch 133, the second transistor 131 is driven by the one-shot pulse to instantaneously discharge the gate-source capacitance charged in the gate electrode of the output transistor, and the constant current of the current source 12 flowing through the second zener diode 151 flows out to the ground through the second switch 133 after discharge. Accordingly, the gate potential of the output transistor is uniformly maintained so that the p-channel output transistor is driven. The output driving voltage clamping unit 150, for example, the second zener diode 151 Z2 of FIGS. 2 or/and 3 protects the output transistor T1 by preventing the source-gate voltage of the p-channel output transistor 30 T1 from exceeding the breakdown voltage BVsg.

The simulation result in accordance with an embodiment of the present invention will be described with reference to FIG. 4.

FIG. 4 is a waveform showing a simulation result of the circuit in accordance with an embodiment in FIG. 2. 20 V is applied as the high voltage power source Vdd, and the circuit, which consists of a p-channel LDMOS with a source-gate voltage Vsg ≤ 12V and a source-drain voltage Vsd ≤ 50V as recommended operating voltages of the output transistor 30 T1, is simulated.

A waveform /A represents a control signal of the first switch 113 A, a waveform /B represents a control signal of the second switch 133 B, a waveform/One_shot represents an output waveform of the one-shot pulse, a waveform /N1/D represents a current flowing in the drain of the second transistor 131 N1 by the one-shot pulse, a waveform /D0/NEG represents a current flowing in the second zener diode 151 Z2, and a waveform /Vg represents the gate potential of the output transistor T1.

The first and second switches 113 A and 133 B are controlled by 0V/5V like the simulation. When the 5V signal is applied to the first switch 113 A, the first switch 113 A is closed and the first transistor 111 P1 of the embodiment circuit is turned on to apply 20V of the gate potential of the output transistor T1 and make a source-gate potential into 0V so that the output transistor T1 is turned off. On the contrary, when the 0V signal is applied to the first switch 113 A and the 5V signal is applied to the second switch 133 B, the first switch 113 A is opened and the second switch 133 B is closed. When the second switch 133 B is closed, the gate-source capacitance of the output transistor T1 is discharged by the one-shot pulse, the gate potential Vg of the output transistor T1 is maintained as 8.687V by the current source 12 and the second zener diode 151 Z2, and the source-gate potential Vsg is Vsg = 20 - 8.687 = 11.723V so that the output transistor T1 is normally turned on with a voltage within the recommended operating voltage. It is possible to check that the gate potential Vg of the output transistor T1 is 8.687V and the output transistor T1 maintains an on-state even though low 100uA flows in the second zener diode 151 Z2.

The operation by the one-shot pulse will be described with reference to FIG. 5. For this, the simulation waveforms within a dotted line section of FIG. 4 are enlarged in FIG. 5.

The one-shot pulse is a pulse generated when a control voltage of the second switch 133 B changes from 0V to 5V and it is possible to check that a pulse signal of 100ns is generated like the simulation result of FIG. 5. By this signal, the second transistor 131 N1 of the circuit in accordance with this embodiment is instantaneously turned on, the gate-source capacitance of the output transistor T1 is discharged with a current of 4mA, and a falling time of the gate voltage Vg of the output transistor T1 is 25ns so that the output transistor T1 is turned on at high speed.

That is, even though a current of 4mA is required to turn on an output transistor at high speed and maintain an on-state of the output transistor like the simulation result of FIG. 5 in a conventional output driving circuit, the circuit in accordance with this embodiment rapidly turns on the output transistor by the one-shot pulse and maintains the on-state of the output transistor with a current of 100us so that it is possible to remarkably reduce current consumption.

Next, a transistor output circuit in accordance with a second embodiment of the present invention will be described with reference to the drawings. FIG. 2 is a circuit diagram showing a transistor output circuit in accordance with an embodiment of the present invention, and FIG. 3 is a circuit diagram showing a transistor output circuit including an output driving circuit in accordance with another embodiment of the present invention.

Referring to FIGS. 2 or/and 3, a transistor output circuit in accordance with this embodiment includes a p-channel output transistor 30, an n-channel output transistor 40, and an output driving circuit 10. In FIGS. 2 or/and 3, connection of the output driving circuit 10 and the p-channel and n-channel output transistors 30 and 40 shows that the output driving circuit 10 complementarily drives the p-channel and n-channel output transistors 30 and 40. At this time, the output driving circuit 10 is an output driving circuit 10 in accordance with the foregoing first embodiment. Therefore, in describing these embodiments, embodiments of the foregoing output driving circuit 10 will be referred, and accordingly, repeated description may be omitted.

Referring to FIGS. 2 or/and 3, a source electrode of the p-channel output transistor 30 is connected to a high voltage power source terminal Vdd, and the p-channel output transistor 30 outputs high voltage power source Vdd through a drain electrode according to its driving. At this time, the output driving circuit 10 in accordance with the foregoing embodiment drives the p-channel output transistor 30.

The n-channel output transistor 40 operates complementarily with the p-channel output transistor 30. The n-channel output transistor 40 outputs power from a drain electrode connected to the drain electrode of the p-channel output transistor 30 to a low voltage power source terminal connected to a source electrode according to its driving. At this time, the output driving circuit 10 in accordance with the foregoing embodiment drives the n-channel output transistor 40 complementarily with driving the p-channel output transistor 30.

At this time, the p-channel output transistor 30 is driven according to on operation of a second switch 133 of a second driving circuit unit 130 of the output driving circuit 10, and the n-channel output transistor 40 is driven according to on operation of a first switch 113, which operates complementarily with the second switch 133.

Further, in accordance with an embodiment of the present invention, an output driving voltage clamping unit 150 of the output driving circuit 10 may include a second zener diode 151 disposed between the high voltage power source terminal Vdd and a gate of the p-channel output transistor 30.

In accordance with another embodiment, the first and second switches 113 and 133 of the output driving circuit 10 may consist of n-channel MOSFETs or n-channel LDMOS FETs.

According to embodiments of the present invention, it is possible to obtain an output driving circuit and a transistor output circuit that can stably operate when a high voltage lower than a source-drain breakdown voltage but higher than a gate-source breakdown voltage is applied to a gate of the output transistor.

Further, according to embodiments of the present invention, it is possible to obtain an output driving circuit and a transistor output circuit that can perform stable operation in a high frequency and moreover, perform stable operation with low current consumption.

It is apparent that various effects which have not been directly mentioned according to the various embodiments of the present invention can be derived by those skilled in the art from various constructions according to the embodiments of the present invention.

The above-embodiments and the accompanying drawings are provided as examples to help understanding of those skilled in the art, not limiting the scope of the present invention. Further, embodiments according to various combinations of the above-described components will be apparently implemented from the foregoing specific descriptions by those skilled in the art. Therefore, the various embodiments of the present invention may be embodied in different forms in a range without departing from the essential concept of the present invention, and the scope of the present invention should be interpreted from the invention defined in the claims. It is to be understood that the present invention includes various modifications, substitutions, and equivalents by those skilled in the art.

## Claims

1. An output driving circuit comprising:
a first driving circuit unit comprising a first transistor driven according to on operation of a first switch to supply high voltage power source to a gate of an output transistor;
a second driving circuit unit comprising a second transistor driven by a one-shot pulse generated according to on operation of a second switch, which operates complementarily with the first switch, to discharge a gate-source capacitance of the output transistor; and
an output driving voltage clamping unit disposed between a high voltage power source terminal and the gate of the output transistor in parallel with the first driving circuit unit to maintain a gate potential of the output transistor discharged according to the on operation of the second switch.

2. The output driving circuit according to claim 1, wherein the second driving circuit unit comprises:
the second switch which operates complementarily with the first switch and discharges a current flowing through the output driving voltage clamping unit to a low voltage power source terminal according to the on operation;
a pulse generator which generates the one-shot pulse for driving the second transistor according to the on operation of the second switch; and
the n-channel second transistor which is driven by the one-shot pulse to discharge the gate-source capacitance of the output transistor.

3. The output driving circuit according to claim 1, wherein the first driving circuit unit comprises:
the first switch;
the p-channel first transistor having a source electrode connected to the high voltage power source terminal and being driven according to the on operation of the first switch to supply the high voltage power source to the gate of the output transistor; and
a first transistor driving voltage clamping unit for clamping a driving voltage supplied from the high voltage power source terminal to a gate of the first transistor according to the on operation of the first switch.

4. The output driving circuit according to claim 2, wherein the first driving circuit unit comprises:
the first switch;
the p-channel first transistor having a source electrode connected to the high voltage power source terminal and being driven according to the on operation of the first switch to supply the high voltage power source to the gate of the output transistor; and
a first transistor driving voltage clamping unit for clamping a driving voltage supplied from the high voltage power source terminal to a gate of the first transistor according to the on operation of the first switch.

5. The output driving circuit according to claim 3, wherein the first transistor driving voltage clamping unit comprises a resistor and a first zener diode which are disposed between the high voltage power source terminal and the gate of the first transistor to be connected each other in parallel.

6. The output driving circuit according to claim 4, wherein the first transistor driving voltage clamping unit comprises a resistor and a first zener diode which are disposed between the high voltage power source terminal and the gate of the first transistor to be connected each other in parallel.

7. The output driving circuit according to claim 3, wherein the first transistor driving voltage clamping unit comprises:
a first zener diode disposed between the high voltage power source terminal and the gate of the first transistor;
a current mirror connected to the first zener diode in parallel; and
a third switch connected to a lower end of the current mirror, an opposite side of the gate of the first transistor, to operate complementarily with the first switch.

8. The output driving circuit according to claim 4, wherein the first transistor driving voltage clamping unit comprises:
a first zener diode disposed between the high voltage power source terminal and the gate of the first transistor;
a current mirror connected to the first zener diode in parallel; and
a third switch connected to a lower end of the current mirror, an opposite side of the gate of the first transistor, to operate complementarily with the first switch.

9. The output driving circuit according to claim 7, wherein the current mirror has a mirror structure of third and fourth transistors of which source electrodes are connected to the high voltage power source terminal, wherein the third and fourth transistors are p-channel MOSFETs or p-channel LDMOS FETs, a drain electrode of the fourth transistor is connected to the gate of the first transistor, a drain electrode of the third transistor is connected to the third switch and gate electrodes of the third and fourth transistors, and the third switch consists of an n-channel MOSFET or an n-channel LDMOS FET.

10. The output driving circuit according to claim 8, wherein the current mirror has a mirror structure of third and fourth transistors of which source electrodes are connected to the high voltage power source terminal, wherein the third and fourth transistors are p-channel MOSFETs or p-channel LDMOS FETs, a drain electrode of the fourth transistor is connected to the gate of the first transistor, a drain electrode of the third transistor is connected to the third switch and gate electrodes of the third and fourth transistors, and the third switch consists of an n-channel MOSFET or an n-channel LDMOS FET.

11. The output driving circuit according to claim 1, wherein the output driving voltage clamping unit comprises a second zener diode disposed between the high voltage power source terminal and the gate of the output transistor.

12. The output driving circuit according to claim 1, wherein a gate-source capacitance of the first transistor is smaller than that of the output transistor.

13. The output driving circuit according to claim 1, wherein the first and second switches consist of n-channel MOSFETs or n-channel LDMOS FETs.

14. The output driving circuit according to claim 1, wherein the output transistor is a p-channel MOSFET or a p-channel LDMOS FET which is driven according to driving of the second driving circuit unit to output the high voltage power source.

15. A transistor output circuit comprising:
a p-channel output transistor of which a source electrode is connected to a high voltage power source terminal and which outputs high voltage power source through a drain electrode according to driving;
an n-channel output transistor which operates complementarily with the p-channel output transistor and outputs power from a drain electrode connected to the drain electrode of the p-channel output transistor to a low voltage power source terminal connected to a source electrode according to driving; and
an output driving circuit according to claim 1 which drives each of the p-channel and n-channel output transistors according to complementary switching operation.

16. The transistor output circuit according to claim 15, wherein an output driving voltage clamping unit of the output driving circuit comprises a second zener diode disposed between the high voltage power source terminal and a gate of the p-channel output transistor.

17. The transistor output circuit according to claim 15, wherein first and second switches of the output driving circuit consist of n-channel MOSFETs or n-channel LDMOS FETs.
